# EUROPEAN PATENT SPECIFICATION

(11) **EP 3 772 095 B1**
(45) Date of publication and mention of the grant of the patent: **08.06.2022**
(21) Application number: 19189127.4
(22) Date of filing: 30.07.2019
(51) Int. Cl.: H01L 23/473

(54) **COOLER**
KÜHLER
REFROIDISSEUR

(43) Date of publication of application: 03.02.2021
(73) Proprietor: BRUSA Elektronik AG, 9466 Sennwald (CH)
(72) Inventor: Wendelspiess, Ueli, 9445 Rebstein (CH)
(74) Representative: Kaminski Harmann

(56) References cited:
- CN-A- 105 514 064

## Description

### FIELD OF THE INVENTION

The present invention relates to a cooler, which in particular is adapted for cooling electronic structural units or assemblies.

### BACKGROUND OF THE INVENTION

As is known, the power dissipation and hence the heat evolution of electronic assemblies are increasing with the power-related further development of the electronic structural elements. It is true that these components are becoming smaller but their efficiencies are increasing and hence efforts to remove the thermal energy increase as well. Furthermore, due to their compactness, these electronic elements are positioned in a smaller space so that once again a higher local heat development results. The power dissipations achieved would be possible only with complicated and bulky cooling bodies when employing fan cooling and are therefore unacceptable. In case of large losses, air cooling therefore clearly reaches its limits.

The new high-performance processors deliver about 70 to 100 W over an area of about 10 cm² and thus achieve a far higher heat flux density. The processor manufacturers predict that a further increase in the waste heat is to be expected in the years ahead. In view of this development, those skilled in the art are considering liquid cooling for such applications. Liquid cooling more effectively dissipates the heat from the electronic assemblies, with the result that a higher power density is possible. Liquid coolers also allow more compact switch cabinets with numerous electronic components and operate very quietly.

An exemplary generic cooling apparatus is disclosed in EP 2 291 859 A1, in which an insert is provided inside a cooling channel, the insert having a plurality of pins forming channels towards a cooler wall and being supplied with coolant via openings in an inclined surface of the inlet which is hit by a coolant flow from the coolant channel.

CN 105 514 064 A (CN ELECT TECH NO 38 RES INST) 20 April 2016 (2016-04-20) discloses a cooler.

### OBJECT OF THE INVENTION

The invention provides an improved cooler, which, while being as compact as possible, permits a more effective cooling structure and a lighter, simpler design.

### SUMMARY OF THE INVENTION

The invention relates to a cooler comprising an inlet, an outlet, a first unit, and a second unit, the inlet configured for feeding the cooler with coolant, the outlet configured for discharging said coolant, the first unit comprising a first plane for receiving a first part to be cooled, a first unit first fin, and a first unit second fin, the first unit first fin extending from a first unit first root to a first unit first fin front, the first unit second fin extending from the first unit first root to a first unit second fin front, the first plane being in uninterrupted thermal contact with the first unit first root, the first unit first fin having a first unit first fin first surface, the first unit second fin having a first unit second fin first surface, the second unit comprising a second unit first fin, the second unit first fin having a second unit first fin first front, a second unit first fin first surface, and a second unit first fin second surface, the second unit first fin located at least in part between the first unit first fin and the first unit second fin such that the first unit first root is adjacent to the second unit first fin first front leaving a first gap, the first unit first fin first surface is abutting the second unit first fin first surface, and the first unit second fin first surface is abutting the second unit first fin second surface, at least one of the first unit first fin first surface and the second unit first fin first surface having a first corrugated structure, the first corrugated structure forming first inbound channels between the first unit first fin first surface and the second unit first fin first surface, at least one first inbound channel being configured for forming a first coolant inbound flow from the first unit first fin first front towards the first unit first root and causing the first coolant inbound flow to impinge and laterally widen on the first unit first root.

At least one of the first unit second fin first surface and the second unit first fin second surface may have a second corrugated structure, the second corrugated structure forming first reverse channels between the first unit second fin first surface and the second unit first fin second surface, the first reverse channels being offset relative to the first inbound channels, each of two neighbouring first reverse channels, which are closest to the first inbound channel, being configured for receiving a part of the impinged and widened first coolant inbound flow and forming a first coolant reverse flow from the first unit first root towards the first unit second fin front.

In another embodiment, the second unit first fin first front may be a second unit first fin front, the first unit second fin having a first unit second fin second surface, the second unit comprising a second unit second fin, the second unit second fin having a second unit second fin front and a second unit second fin first surface, the second unit first fin extending from a second unit first root to the second unit first fin front, the second unit second fin extending from the second unit first root to the second unit second fin front, the first unit second fin located between the second unit first fin and the second unit second fin such that the second unit first root is adjacent to the first unit second fin front leaving a second gap, the first unit second fin second surface is abutting the second unit second fin first surface, the first reverse channels being second inbound channels, the first coolant reverse flow being a second coolant inbound flow, at least one second inbound channel being configured for forming the second coolant inbound flow from the second unit first fin front towards the second unit first root, causing the second coolant inbound flow to impinge and laterally widen on the second unit first root, at least one of the second unit second fin first surface and the first unit second fin second surface having a third corrugated structure, the third corrugated structure forming second reverse channels between the second unit second fin first surface and the first unit second fin second surface, the second reverse channels being offset relative to the second inbound channels, each of two neighbouring second reverse channels, which are closest to said second inbound channel, being configured for receiving a part of the impinged and widened second coolant inbound flow and forming a second coolant reverse flow from the second unit first root towards the second unit second fin front.

The second unit first fin may have a second unit first fin second front opposing the second unit first fin first front, wherein the cooler comprises a third unit, the third unit comprises a third unit first fin, and a third unit second fin, the third unit first fin extending from a third unit first root to a third unit first fin front, the third unit second fin extending from the third unit first root to a third unit second fin front, the third unit first fin having a third unit first fin first surface, the third unit second fin having a third unit second fin first surface.

In a further embodiment, the second unit first fin is further located at least in part between the third unit first fin and the third unit second fin such that the third unit first root is adjacent to the second unit first fin second front leaving a third gap, the third unit first fin first surface is abutting the second unit first fin first surface, and the third unit second fin first surface is abutting the second unit first fin second surface.

The second unit first fin may further be located at least in part neighbouring the third unit first fin such that the third unit first root is adjacent to the second unit first fin second front leaving a fourth gap, the third unit first fin first surface is abutting the second unit first fin second surface the third unit first root being arranged for receiving coolant from the inlet.

The third unit may comprise a plane for receiving a second part to be cooled and the third plane being in uninterrupted thermal contact with the third unit first root.

The cooler may be an electronic element cooler and the first part to be cooled being an electronic element.

In another embedment, the second unit may be of a plastic material.

The inlet may be arranged and configured to be upstream to the first gap, and the outlet being arranged and configured to be downstream to the first reverse channels.

In another embedment, the first unit or the second unit is a finned component of a material containing aluminium.

The first unit first root may be configured for causing a split-up of the first coolant inbound flow into two part-flows, the two part-flows entering said two neighbouring first reverse channels.

In another embedment, the first unit first root is one side of a heat-conducting cooler wall, the first plane being an opposite side of the heat-conducting cooler wall.

The first unit and the second unit may be configured for forming a housing.

In another embedment, the first unit and the third unit are configured for forming a housing, in particular and the second unit is configured for forming the housing in combination with the first and third unit.

### BRIEF DESCRIPTION OF THE DRAWINGS

By way of example only, preferred embodiments of the invention will be described more fully hereinafter with reference to the accompanying figures, wherein:
Figures 1 to 5 show different view of a first embodiment of a cooler according to the invention;
Figure 6 shows an abstracted view of a coolant flow through a cooler according to one embodiment of the invention;
Figures 7 to 11 show different possible aspects of embodiments of a cooler according to the invention;
Figures 12 to 14 show different views of a further embodiment of a cooler according to the invention;
Figure 15 shows a further modification of an embodiment of a cooler according to the invention;
Figures 16, 17 and 18 show a further varied aspect of an embodiment of a cooler according to the invention;
Figures 19 and 20 show different views of yet a further embodiment of a cooler according to the invention;
Figures 21 and 22 shows different views of yet another embodiment of a cooler according to the invention;
Figure 23 shows an exemplary configuration of how a part to be cooled is applied on the first plane;

### DETAILED DESCRIPTION OF THE DRAWINGS

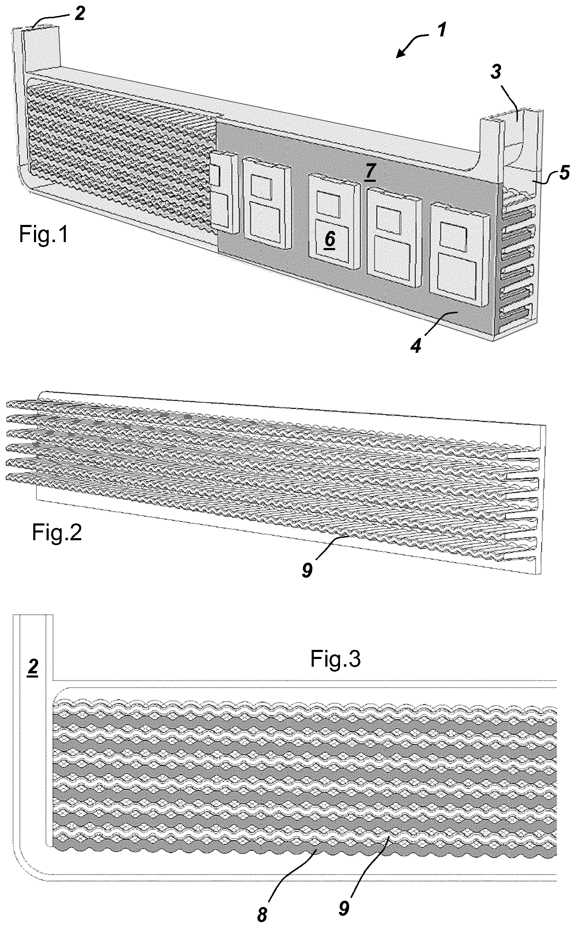

Figure 1 shows a first embodiment of a cooler 1 according to the invention. The cooler 1 has an inlet 2 and an outlet 3, a first unit 4 and a second unit 5. A first part to be cooled 6, in particular an electronic element, is applied on a first surface 7 of the first unit 4. The cooler is fed by the inlet 2 with coolant, which distributes in a lower part of the cooler, more or less evenly along a long side of the cooler, and is then guided forth and back through a plurality of channels formed by fins of the first and second unit until it arrives in an upper part of the cooler which accesses the outlet 3 where the coolant is discharged. The formations of the inlet 2 and/or outlet 3 can be part of the first and/or second unit or can be separate elements connectable with the first and second unit. The first and second unit can together form a housing. In a particular embodiment, the first and second unit form a housing together with at least one of a separate inlet, a separate outlet, and a separate wall element.

In the example shown in figure 1, the fed coolant first comes into contact with a fin of the first unit. However, as well, the first fin to come into contact with the coolant can also be from the second unit. The fins of the first and second unit intertwine, i.e. they are put together such that the fins of the first unit and the second unit alternate. In this way, the coolant is sent forth and back, at every turn impinging on the backside of the plate having the first surface 7. The area of impinging is named "root" in the following. The term "intertwine" is to be interpreted as implying the involved units both (a) having at least in some parts contact and (b) having at least in some parts no contact at all.

To more easily understand the structure, figure 2 shows a section of the second unit of figure 1. It is noted that such structure is by way of example only. The inventive principle can also be achieved with various other structures, as will be shown below. The fins 9 in figure 2 ("second unit fins") have a waved profile. They extend from a root section ("second unit roots") to a front section ("second unit fronts").

Figure 3 shows a cross-sectional view along the long side and perpendicular to an alignment of the corrugated structure of the fins. In this situation, the first and second unit are stuck together, which is why the second unit fins 9 are visible here as well as first unit fins 8. A particular feature of the embodiment of figure 3 is that a longitudinal orientation of the fins a slight inclination in order to further improve an even longitudinal distribution of the coolant to achieve a uniform pressure drop. However, this inclination is optional and not necessary in all embodiments of the invention. Each of the corrugated structures has for example a waved pattern, a zigzag pattern, a meander pattern, or a trapezoidal pattern

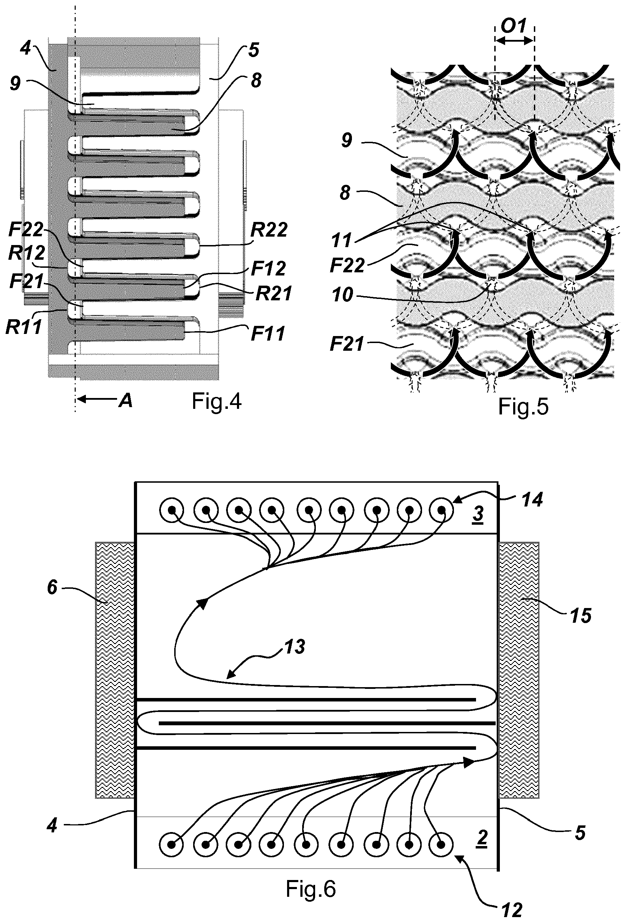

Figure 4 shows a side view such that the long side is essentially perpendicular to the paper level and one can see the single fins 8 of the first unit and the single fins 9 of the second unit being intertwined. The coolant by which the cooler is fed, arrives below the first fin of the first unit 8 on the bottom where it distributes along the long side. The coolant then finds its way around the front section F11 of said first fin to travel between said first fin of the first unit and the first fin of the second unit. This mechanism will be explained more generally for figure 6 below. Said travel between two fins takes place in channels which are formed with a corrugated structure on at least one of the participating fins.

Figure 5 shows an example for this formation of channels, which is in accordance with the structure of the fins in figures 1 to 4 where the fins of both of the first and second unit have a waved form. Figure 5 shows the cross-section view of figure 3 in greater detail from the first unit 4 towards the second unit 5. This cross-section view corresponds to the cut plane A indicated in figure 4. As can be seen in figure 5, the fins are arranged and abutting one another in such a way that said waves are offset relative to each other to form the channels. That is to say, the reverse channels are shifted by the offset O1 relative to the inbound channels.

A coolant flow is indicated by the full arrows and the dashed arrows. The full arrow flow could be seen from the perspective of the cutting plane A, the dashed arrow flow is a reverse flow actually covered by the fins from this perspective. So, the fins 8 are actually cut in this view, and from the fins 9 we can see the front section uncut. The area of full arrows is a root (section) of the first unit where a cooling impingement takes place. After the coolant coming from an inbound flow 10 frontally impinged on the root, it is split up into two flow parts laterally diverging into reverse channels 11 to the next "floor" or "level". This split-up of the single channel flows allows an extra cooling effect which increases the overall efficiency. Apart from the ever first inbound flow in the system, all other inbound flows are reverse flows from a respective preceding inbound flow.

An abstracted cross-sectional side view of the first embodiment is shown in figure 6. The arrow heads 12 indicate a direction from the paper level out of the plane and show an exemplary flow of coolant from the inlet feeding the cooler. The lines 13 indicate the flow progress of the coolant through the cooler, i.e. from the inlet 2 towards an outlet 3, wherein the arrow heads 14 again are directed out of the plane, i.e. perpendicular to the paper level, and indicate how the used coolant is discharged. Of course, the flowing direction of the coolant in the inlet relative to the outlet can also be opposed (from the top to the bottom). In particular, the flow direction in the inlet and/or the outlet is not necessarily perpendicular to the paper level in the view of figure 1. In this first embodiment, the cooler can cool two parts 6 and 15 which are arranged on planes of the units 4 and respectively 5. These part carrying planes are the opposite sides of the respective roots of the units (see R11, R12 and R21, R22 in figure 4). Figure 6 shows only two fins of the first unit 4 and second unit 5, however this only serves the illustration of the coolant flowing principle and of course the respective assemblies can comprise many more fins.

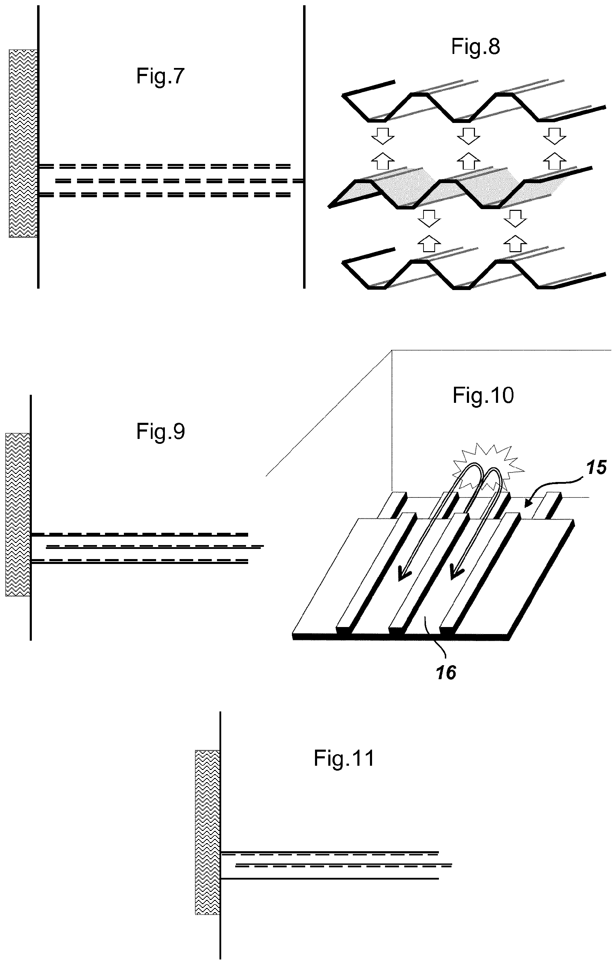

While figure 6 is undescriptive about which fins and/or which side of the fins has a corrugated structure, figures 7, 9, 11, 12, 14, and 15 show some of the various possibilities.

The corrugations of the embodiment according to figures 1 to 5 are represented by the layout of figure 7. The double dashed line means both sides of the fins have a corrugated structure, in this case a wave structure. A further possibility of a double-sided structure of fins in shown in figure 8, wherein the indentations are abutting in an assembled situation (indicated by the arrows). In other words, the structure is not necessarily rounded, it can also have an edged meander-type of shape. The sketches of figures 7, 9, 11,12, 15, 16, and 21 show the fins being spaced apart, however, these figures are only for demonstration of the constellations, not to show the true dimensions.

A further example is abstractedly shown in figure 9, where the fins are plates having a smooth surface on one side and having corrugations on the other side. One embodiment for this case is shown in the 3D view of figure 10, where the corrugated structure is achieved with grooves cut out from a plate, or with bars added to a plate. When the first unit fins and the second unit fins are contacting with an offset regarding their corrugations, they will form inbound channels 15 and reverse channels 16. The impingement on the root surface is indicated with the splash symbol and the split-up is indicated with the double-lined arrow showing the flowing direction of the coolant. Why figure 9 is undetermined about a second unit wall or root will be understood when arriving at another embodiment further below. Figure 11 shows an example of fin structures that corresponds to the example of figures 9 and 10 just the other way around.

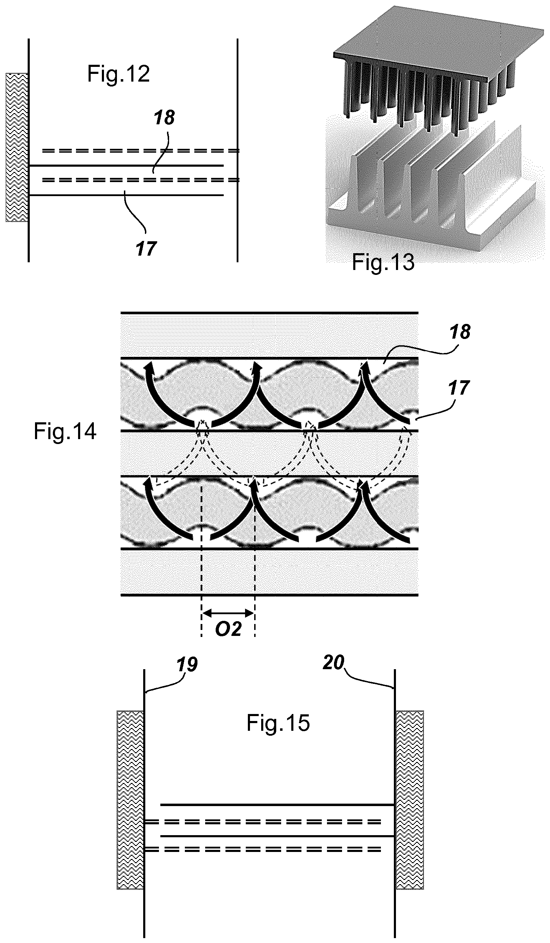

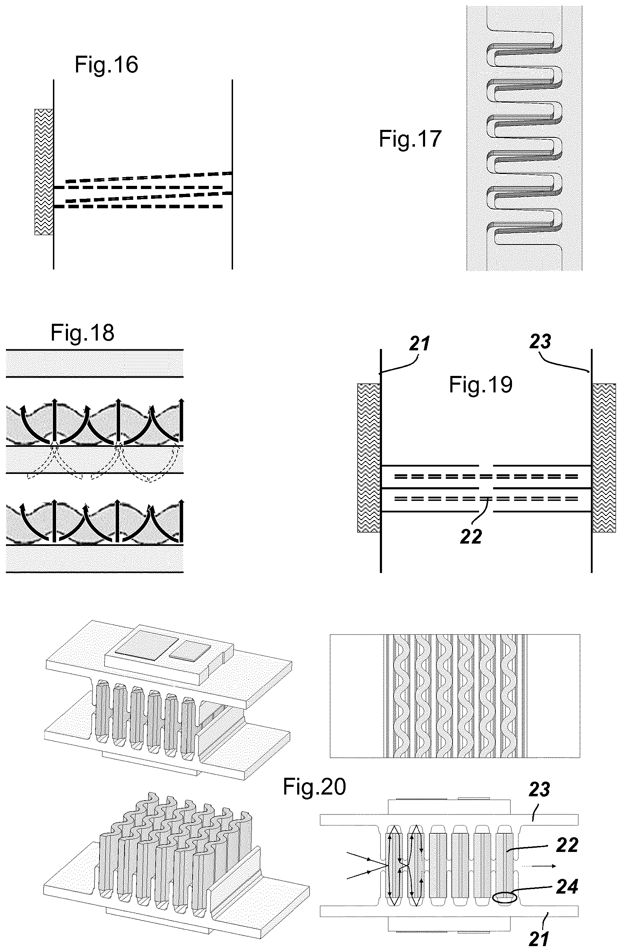

A further embodiment of a combination of first and second unit of a cooler is shown with figures 12, 13, and 14, where the second unit can be of a material that is cheaper to manufacture, e.g. plastic. The first unit having a surface for receiving a part to be cooled can be made of a material that has very good thermal conductivity, e.g. aluminium. Machining aluminium with smooth fins is easier compared to the waved-structured fins shown in figures 1 to 5. Figure 12 shows on the left said first unit with the smooth plates and on the right the second unit, which (can be, but here) is not intended for receiving a part to be cooled, having a double-sided corrugated structure. The fins of the first and second unit are abutting at least such that the form an inbound channel 17. In particular, the channel 17 is at least formed in the area of the second unit fin front, i.e. shortly before the coolant is entering the root area to impinge on the first unit wall. Figure 14 shows an example how the fins are abutting and how the coolant is redirected. The reverse channels 18 are in this case also starting right at the second unit fronts where the first unit fins are abutting. It would be possible to keep some distance for the reverse flow such that no reverse "channels" are formed but a reverse flow (see Figure 18). It must be noted that most importantly, it is the inbound coolant which is formed by channels in order to impinge on the root area in the form of a jet that will split up or broaden or swirl after it impinged on the root. In the shown example (figure 14), the reverse flow is immediately introduced in reverse channels 18 which are arranged offset to the inbound channels 17. This channel offset O2 is to be understood with reference to an axis which is aligned perpendicular to the channels and parallel to the fins.

Figure 15 shows a similar constellation, wherein only the first unit 19 has double-sided structured fins and the second unit has plain fins and a second surface for receiving electronics to cool. A person of skill in the art will see that there are various possibilities to apply the inventive principle.

Figure 16 shows in an exaggerated sketch that the fins of the first unit have an inclination relative to the fins of the second unit. This is shown with the example of each of the units having double-sidedly structured fins, however other structure constellations may be applicable. Figure 17 shows this inclination with a side view of intertwining fins. The inbound channels are only formed shortly before the coolant hits the impingement zone (root) at the respective root. As a result, after impinging, the coolant is not introduced into a reverse channel. However, the inbound channels forming little jets that can impinge on the root still leads to an advantageous cooling effect according to the invention. After impinging, the coolant is whirled around generating turbulences. Figure 18 shows how the reverse flow is entering an open duct instead of the offset channels as known from the other embodiments.

Figures 19 and the four parts of figure 20 show an embodiment with a first unit 21, a second unit 22, and a third unit 23. The second unit is in this case an insert 22 having a both-sidedly corrugated structure. As second unit 22 counts every structured fin that is inserted into the cavities (so not only the one labelled in figure 19, but the whole set). This set of fins 22 can be clamped between the first and second unit 21, 23. To fix the second unit 22 without clogging the root section, said assemblies 21, 23 may have shoulders 24 for the fronts of the second unit to abut. However, other means such as notches on the fins of the second unit 22 could also be another embodiment for fixating the second unit 22 in the assembly. Due to the shoulders 24, the waved fins keep a gap to the roots such that the coolant can flow through the construction as indicated in the lower right part of figure 20. The coolant is fed between the first unit 21 and the third unit 23 and splits up into the shown two opposing directions towards the first unit first root and the third unit first root. The second unit 22 fins abutting the fins of the first and third unit forms channels in which the coolant is flowing. After impinging on the respective root it flows back on the other side of the second unit fin where channels are formed, too. At the area where the coolant now confronting, it distributes to the next "floor" or "storey", i.e. it flows around the second fins of the first and third unit, where the second unit second fin is again forming inbound channels. This embodiment is also relatively simple to machine while still providing the inventive principle. For example, as second unit, a plastic injection moulding part can be used since it does not need to necessarily have a good thermal conductivity and its purpose is mainly to form the inbound channels and the reverse channels offset to the inbound channels.

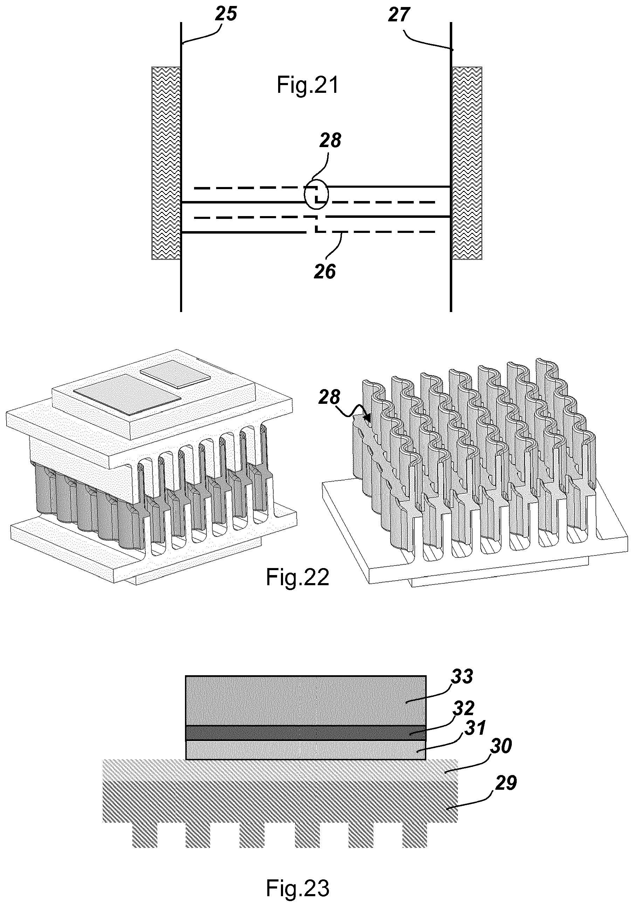

Another embodiment is shown with figures 21 and 22, where a second unit 26 is a set of corrugated sheets each having a bend in the middle. The first unit 25 and the third unit 27 are similar to the ones from the embodiment of figures 19 and 20, i.e. ribbed aluminium parts, with the difference that they are arranged offset relative to each other such that the fins can each rest on one of said bends in the second unit fins. In the area of each bend of the second unit fins there is an opening 28 for conducting the coolant. In this way, the coolant is guided through this labyrinth in the inventive manner wherein upon impinging the coolant flow is split apart and discharged from the root area in offset reverse channels.

Whatever way the cooler according to the invention might be embodied, a part to be cooled can be applied with the following configuration. The heatsink can be coated with thermally sprayed ceramic as electrical insulation. Between the ceramic layer and the heatsink, an intermediate layer can be applied to relieve the thermal stresses. The semiconductor device (=part to be cooled) can be mounted by means of a thermal paste and a mechanical fixation or by thermally conductive adhesives. With this special attachment, the electronic part is electrically isolated but the generated heat can be dissipated very effectively.

An exemplary configuration is shown in figure 23. The first unit 29 has on the opposite site of the roots (where the cooling impingement takes place) the surface to receive the part to be cooled 33. Said surface may have a coating 30 which is flame-sprayed and only 100 - 300 micrometer thin. For example, such coating is made of Al₂O₃ or AIN. Intermediate layer 31 is optional and can consist of a copper-based material. Thermal conductive layer 32 can for example be a glue, paste, or wax which is thermally conductive. This solution avoids the manufacturing step of soldering and allows for lesser interfaces compared to solutions known in the art.

## Claims

1. A cooler comprising an inlet, an outlet, a first unit, and a second unit,
- the inlet configured for feeding the cooler with coolant,
- the outlet configured for discharging said coolant,
- the first unit comprising a first plane for receiving a first part to be cooled, a first unit first fin, and a first unit second fin,
o the first unit first fin extending from a first unit first root to a first unit first fin front,
∘ the first unit second fin extending from the first unit first root to a first unit second fin front,
∘ the first plane being in uninterrupted thermal contact with the first unit first root,
∘ the first unit first fin having a first unit first fin first surface,
∘ the first unit second fin having a first unit second fin first surface,
- the second unit comprising a second unit first fin,
- the second unit first fin having a second unit first fin first front, a second unit first fin first surface, and a second unit first fin second surface,
- the second unit first fin located at least in part between the first unit first fin and the first unit second fin such that
∘ the first unit first root is adjacent to the second unit first fin first front leaving a first gap,
∘ the first unit first fin first surface is abutting the second unit first fin first surface, and
∘ the first unit second fin first surface is abutting the second unit first fin second surface,
- at least one of the first unit first fin first surface and the second unit first fin first surface having a first corrugated structure,
- the first corrugated structure forming first inbound channels between the first unit first fin first surface and the second unit first fin first surface,
- at least one first inbound channel being configured for
∘ forming a first coolant inbound flow from the first unit first fin first front towards the first unit first root and
∘ causing the first coolant inbound flow to impinge and laterally widen on the first unit first root.

2. The cooler according to claim 1,
- at least one of the first unit second fin first surface and the second unit first fin second surface having a second corrugated structure,
- the second corrugated structure forming first reverse channels between the first unit second fin first surface and the second unit first fin second surface,
- the first reverse channels being offset relative to the first inbound channels,
- each of two neighbouring first reverse channels, which are closest to the first inbound channel, being configured for
∘ receiving a part of the impinged and widened first coolant inbound flow and
∘ forming a first coolant reverse flow from the first unit first root towards the first unit second fin front.

3. The cooler according to claim 2,
- the second unit first fin first front being a second unit first fin front,
- the first unit second fin having a first unit second fin second surface,
- the second unit comprising a second unit second fin,
- the second unit second fin having a second unit second fin front and a second unit second fin first surface,
- the second unit first fin extending from a second unit first root to the second unit first fin front,
- the second unit second fin extending from the second unit first root to the second unit second fin front,
- the first unit second fin located between the second unit first fin and the second unit second fin such that
∘ the second unit first root is adjacent to the first unit second fin front leaving a second gap,
∘ the first unit second fin second surface is abutting the second unit second fin first surface,
- the first reverse channels being second inbound channels,
- the first coolant reverse flow being a second coolant inbound flow,
- at least one second inbound channel being configured for
∘ forming the second coolant inbound flow from the second unit first fin front towards the second unit first root,
∘ causing the second coolant inbound flow to impinge and laterally widen on the second unit first root,
- at least one of the second unit second fin first surface and the first unit second fin second surface having a third corrugated structure,
- the third corrugated structure forming second reverse channels between the second unit second fin first surface and the first unit second fin second surface,
- the second reverse channels being offset relative to the second inbound channels,
- each of two neighbouring second reverse channels, which are closest to said second inbound channel, being configured for
∘ receiving a part of the impinged and widened second coolant inbound flow and
∘ forming a second coolant reverse flow from the second unit first root towards the second unit second fin front.

4. The cooler according to claim 2,
- the second unit first fin having a second unit first fin second front opposing the second unit first fin first front,
- the cooler comprising a third unit,
- the third unit comprising a third unit first fin, and a third unit second fin,
∘ the third unit first fin extending from a third unit first root to a third unit first fin front,
∘ the third unit second fin extending from the third unit first root to a third unit second fin front,
∘ the third unit first fin having a third unit first fin first surface,
∘ the third unit second fin having a third unit second fin first surface.

5. The cooler according to claim 4,
- the second unit first fin further located at least in part between the third unit first fin and the third unit second fin such that
∘ the third unit first root is adjacent to the second unit first fin second front leaving a third gap,
∘ the third unit first fin first surface is abutting the second unit first fin first surface, and
∘ the third unit second fin first surface is abutting the second unit first fin second surface.

6. The cooler according to claim 4,
- the second unit first fin further located at least in part neighbouring the third unit first fin such that
∘ the third unit first root is adjacent to the second unit first fin second front leaving a fourth gap,
∘ the third unit first fin first surface is abutting the second unit first fin second surface
- the third unit first root being arranged for receiving coolant from the inlet.

7. The cooler according to any of claims 4 to 6,
∘ the third unit comprising a plane for receiving a second part to be cooled and
∘ the third plane being in uninterrupted thermal contact with the third unit first root.

8. The cooler according to any of the preceding claims,
- the cooler being an electronic element cooler and
- the first part to be cooled being an electronic element.

9. The cooler according to any of the preceding claims,
- the second unit being of a plastic material.

10. The cooler according to any of the preceding claims,
- the inlet being arranged and configured to be upstream to the first gap, and
- the outlet being arranged and configured to be downstream to the first reverse channels.

11. The cooler according to any of the preceding claims,
- the first unit or the second unit being a finned component of a material containing aluminium.

12. The cooler according to any of the preceding claims,
- the first unit first root is configured for causing a split-up of the first coolant inbound flow into two part-flows,
- the two part-flows entering said two neighbouring first reverse channels.

13. The cooler according to any of the preceding claims,
- the first unit first root being one side of a heat-conducting cooler wall,
- the first plane being an opposite side of the heat-conducting cooler wall.

14. The cooler according to any of the preceding claims,
- the first unit and the second unit are configured for forming a housing.

15. The cooler according to any of claims 4 to 13,
- the first unit and the third unit are configured for forming a housing, in particular and the second unit is configured for forming the housing in combination with the first and third unit.

## Patentansprüche

1. Kühler, umfassend einen Einlass, einen Auslass, eine erste Einheit und eine zweite Einheit,
- wobei der Einlass dazu konfiguriert ist, dem Kühler Kühlmittel zuzuführen,
- wobei der Auslass dazu konfiguriert ist, das Kühlmittel abzulassen,
- wobei die erste Einheit eine erste Ebene zum Aufnehmen eines ersten zu kühlenden Teils, eine erste Lamelle der ersten Einheit und eine zweite Lamelle der ersten Einheit umfasst,
∘ wobei sich die erste Lamelle der ersten Einheit von einer ersten Wurzel der ersten Einheit zu einer Vorderseite der ersten Lamelle der ersten Einheit erstreckt.
∘ wobei sich die zweite Lamelle der ersten Einheit von der ersten Wurzel der ersten Einheit zu einer Vorderseite der zweiten Lamelle der ersten Einheit erstreckt,
∘ wobei die erste Ebene in ununterbrochenem thermischen Kontakt mit der ersten Wurzel der ersten Einheit steht,
∘ wobei die erste Lamelle der ersten Einheit eine erste Fläche der ersten Lamelle der ersten Einheit aufweist,
∘ wobei die zweite Lamelle der ersten Einheit eine erste Fläche der zweiten Lamelle der ersten Einheit aufweist,
- wobei die zweite Einheit eine erste Lamelle der zweiten Einheit umfasst,
- wobei die erste Lamelle der zweiten Einheit eine erste Vorderseite der ersten Lamelle der zweiten Einheit, eine erste Fläche der ersten Lamelle der zweiten Einheit und eine zweite Fläche der ersten Lamelle der zweiten Einheit aufweist,
- wobei sich die erste Lamelle der zweiten Einheit zumindest teilweise zwischen der ersten Lamelle der ersten Einheit und der zweiten Lamelle der ersten Einheit befindet, sodass
∘ die erste Wurzel der ersten Einheit benachbart zu der ersten Vorderseite der ersten Lamelle der zweiten Einheit ist, wobei eine erste Lücke gelassen wird,
∘ die erste Fläche der ersten Lamelle der ersten Einheit an die erste Fläche der ersten Lamelle der zweiten Einheit angrenzt und
∘ die erste Fläche der zweiten Lamelle der ersten Einheit an die zweite Fläche der ersten Lamelle der zweiten Einheit angrenzt,
- wobei mindestens eine von der ersten Fläche der ersten Lamelle der ersten Einheit und der ersten Fläche der ersten Lamelle der zweiten Einheit eine erste gewellte Struktur aufweist,
- wobei die erste gewellte Struktur erste nach innen gerichtete Kanäle zwischen der ersten Fläche der ersten Lamelle der ersten Einheit und der ersten Fläche der ersten Lamelle der zweiten Einheit bildet,
- wobei mindestens ein erster nach innen gerichteter Kanal konfiguriert ist zum
∘ Bilden eines ersten nach innen gerichteten Kühlmittelstroms von der ersten Vorderseite der ersten Lamelle der ersten Einheit zu der ersten Wurzel der ersten Einheit und
∘ Veranlassen, dass der erste nach innen gerichtete Kühlmittelstrom auf die erste Wurzel der ersten Einheit auftrifft und sich dort lateral ausweitet.

2. Kühler nach Anspruch 1,
- wobei mindestens eine der ersten Fläche der zweiten Lamelle der ersten Einheit und der zweiten Fläche der ersten Lamelle der zweiten Einheit eine zweite gewellte Struktur aufweist,
- wobei die zweite gewellte Struktur erste Rückkanäle zwischen der ersten Fläche der zweiten Lamelle der ersten Einheit und der zweiten Fläche der ersten Lamelle der zweiten Einheit bildet,
- wobei die ersten Rückkanäle in Bezug auf die ersten nach innen gerichteten Kanäle versetzt sind,
- wobei jeder von zwei benachbarten ersten Rückkanälen, die sich am nächsten zu dem ersten nach innen gerichteten Kanal befinden, konfiguriert ist zum
∘ Aufnehmen eines Teils des aufgetroffenen und ausgeweiteten ersten nach innen gerichteten Kühlmittelstroms und
∘ Bilden eines ersten Kühlmittelrückstroms von der ersten Wurzel der ersten Einheit zur Vorderseite der zweiten Lamelle der ersten Einheit.

3. Kühler nach Anspruch 2,
- wobei die erste Vorderseite der ersten Lamelle der zweiten Einheit eine Vorderseite der ersten Lamelle der zweiten Einheit ist,
- wobei die zweite Lamelle der ersten Einheit eine zweite Fläche der zweiten Lamelle der ersten Einheit aufweist,
- wobei die zweite Einheit eine zweite Lamelle der zweiten Einheit umfasst,
- wobei die zweite Lamelle der zweiten Einheit eine Vorderseite der zweiten Lamelle der zweiten Einheit und eine erste Fläche der zweiten Lamelle der zweiten Einheit aufweist,
- wobei sich die erste Lamelle der zweiten Einheit von einer ersten Wurzel der zweiten Einheit zur Vorderseite der ersten Lamelle der zweiten Einheit erstreckt,
- wobei sich die zweite Lamelle der zweiten Einheit von der ersten Wurzel der zweiten Einheit zur Vorderseite der zweiten Lamelle der zweiten Einheit erstreckt,
- wobei sich die zweite Lamelle der ersten Einheit zwischen der ersten Lamelle der zweiten Einheit und der zweiten Lamelle der zweiten Einheit befindet, sodass
∘ die erste Wurzel der zweiten Einheit benachbart zu der Vorderseite der zweiten Lamelle der ersten Einheit ist, wobei eine zweite Lücke gelassen wird,
∘ die zweite Fläche der zweiten Lamelle der ersten Einheit an die erste Fläche der zweiten Lamelle der zweiten Einheit angrenzt,
- wobei die ersten Rückkanäle zweite nach innen gerichtete Kanäle sind,
- wobei der erste Kühlmittelrückstrom ein zweiter nach innen gerichteter Kühlmittelstrom ist,
- wobei mindestens ein zweiter nach innen gerichteter Kanal konfiguriert ist zum
∘ Bilden des zweiten nach innen gerichteten Kühlmittelstroms von der Vorderseite der ersten Lamelle der zweiten Einheit zur ersten Wurzel der zweiten Einheit,
∘ Veranlassen, dass der zweite nach innen gerichtete Kühlmittelstrom auf die erste Wurzel der zweiten Einheit auftrifft und sich dort lateral ausweitet,
- wobei mindestens eine der ersten Fläche der zweiten Lamelle der zweiten Einheit und der zweiten Fläche der zweiten Lamelle der ersten Einheit eine dritte gewellte Struktur aufweist,
- wobei die dritte gewellte Struktur zweite Rückkanäle zwischen der ersten Fläche der zweiten Lamelle der zweiten Einheit und der zweiten Fläche der zweiten Lamelle der ersten Einheit bildet,
- wobei die zweiten Rückkanäle in Bezug auf die zweiten nach innen gerichteten Kanäle versetzt sind,
- wobei jeder von zwei benachbarten zweiten Rückkanälen, die sich am nächsten zu dem zweiten nach innen gerichteten Kanal befinden, konfiguriert ist zum
∘ Aufnehmen eines Teils des aufgetroffenen und ausgeweiteten zweiten nach innen gerichteten Kühlmittelstroms und
∘ Bilden eines zweiten Kühlmittelrückstroms von der ersten Wurzel der zweiten Einheit zur Vorderseite der zweiten Lamelle der zweiten Einheit.

4. Kühler nach Anspruch 2,
- wobei die erste Lamelle der zweiten Einheit eine zweite Vorderseite der ersten Lamelle der zweiten Einheit aufweist, die der ersten Vorderseite der ersten Lamelle der zweiten Einheit gegenüberliegt,
- wobei der Kühler eine dritte Einheit umfasst,
- wobei die dritte Einheit eine erste Lamelle der dritten Einheit und eine zweite Lamelle der dritten Einheit umfasst,
∘ wobei sich die erste Lamelle der dritten Einheit von einer ersten Wurzel der dritten Einheit zu einer Vorderseite der ersten Lamelle der dritten Einheit erstreckt,
∘ wobei sich die zweite Lamelle der dritten Einheit von der ersten Wurzel der dritten Einheit zu einer Vorderseite der zweiten Lamelle der dritten Einheit erstreckt,
∘ wobei die erste Lamelle der dritten Einheit eine erste Fläche der ersten Lamelle der dritten Einheit aufweist,
∘ wobei die zweite Lamelle der dritten Einheit eine erste Fläche der zweiten Lamelle der dritten Einheit aufweist.

5. Kühler nach Anspruch 4,
- wobei sich die erste Lamelle der zweiten Einheit ferner zumindest teilweise zwischen der ersten Lamelle der dritten Einheit und der zweiten Lamelle der dritten Einheit befindet, sodass
∘ die erste Wurzel der dritten Einheit benachbart zur zweiten Vorderseite der ersten Lamelle der zweiten Einheit ist, wobei eine dritte Lücke gelassen wird,
∘ die erste Fläche der ersten Lamelle der dritten Einheit an die erste Fläche der ersten Lamelle der zweiten Einheit angrenzt und
∘ die erste Fläche der zweiten Lamelle der dritten Einheit an die zweite Fläche der ersten Lamelle der zweiten Einheit angrenzt.

6. Kühler nach Anspruch 4,
- wobei sich die erste Lamelle der zweiten Einheit ferner zumindest teilweise benachbart zu der ersten Lamelle der dritten Einheit befindet, sodass
∘ die erste Wurzel der dritten Einheit benachbart zu der zweiten Vorderseite der ersten Lamelle der zweiten Einheit ist, wobei eine vierte Lücke gelassen wird,
∘ die erste Fläche der ersten Lamelle der dritten Einheit an die zweite Fläche der ersten Lamelle der zweiten Einheit angrenzt,
- wobei die erste Wurzel der dritten Einheit zum Aufnehmen von Kühlmittel aus dem Einlass angeordnet ist.

7. Kühler nach einem der Ansprüche 4 bis 6,
∘ wobei die dritte Einheit eine Ebene zum Aufnehmen eines zweiten zu kühlenden Teils umfasst und
∘ wobei die dritte Ebene in ununterbrochenem thermischen Kontakt mit der ersten Wurzel der dritten Einheit steht.

8. Kühler nach einem der vorhergehenden Ansprüche,
- wobei der Kühler ein Kühler für elektronische Elemente ist und
- wobei das erste zu kühlende Teil ein elektronisches Element ist.

9. Kühler nach einem der vorhergehenden Ansprüche,
- wobei die zweite Einheit aus einem Kunststoffmaterial besteht.

10. Kühler nach einem der vorhergehenden Ansprüche,
- wobei der Einlass derart angeordnet und konfiguriert ist, dass er sich stromaufwärts der ersten Lücke befindet, und
- wobei der Auslass derart angeordnet und konfiguriert ist, dass er sich stromabwärts der ersten Rückkanäle befindet.

11. Kühler nach einem der vorhergehenden Ansprüche,
- wobei die erste Einheit oder die zweite Einheit eine Komponente mit Lamellen aus einem Material, das Aluminium enthält, ist.

12. Kühler nach einem der vorhergehenden Ansprüche,
- wobei die erste Wurzel der ersten Einheit dazu konfiguriert ist, eine Aufteilung des ersten nach innen gerichteten Kühlmittelstroms in zwei Teilströme zu veranlassen,
- wobei die zwei Teilströme in die zwei benachbarten ersten Rückkanäle eintreten.

13. Kühler nach einem der vorhergehenden Ansprüche,
- wobei die erste Wurzel der ersten Einheit eine Seite einer wärmeleitenden Kühlerwand ist,
- wobei die erste Ebene eine gegenüberliegende Seite der wärmeleitenden Kühlerwand ist.

14. Kühler nach einem der vorhergehenden Ansprüche,
- wobei die erste Einheit und die zweite Einheit zum Bilden eines Gehäuses konfiguriert sind.

15. Kühler nach einem der Ansprüche 4 bis 13,
- wobei die erste Einheit und die dritte Einheit zum Bilden eines Gehäuses konfiguriert sind insbesondere und die zweite Einheit zum Bilden des Gehäuses in Kombination mit der ersten und dritten Einheit konfiguriert ist.

## Revendications

1. Refroidisseur comprenant une entrée, une sortie, une première unité, et une deuxième unité,
- l'entrée étant configurée pour alimenter le refroidisseur en réfrigérant,
- la sortie étant configurée pour évacuer ledit réfrigérant,
- la première unité comprenant un premier plan pour recevoir une première partie à refroidir, une première ailette de première unité, et une seconde ailette de première unité,
o la première ailette de première unité s'étendant d'un premier pied de première unité à un front de première ailette de première unité,
o la seconde ailette de première unité s'étendant du premier pied de première unité à un front de seconde ailette de première unité,
o le premier plan étant en contact thermique ininterrompu avec le premier pied de première unité,
o la première ailette de première unité ayant une première surface de première ailette de première unité,
o la seconde ailette de première unité ayant une première surface de seconde ailette de première unité,
- la deuxième unité comprenant une première ailette de deuxième unité,
- la première ailette de deuxième unité ayant un premier front de première ailette de deuxième unité, une première surface de première ailette de deuxième unité, et une seconde surface de première ailette de deuxième unité,
- la première ailette de deuxième unité étant située au moins en partie entre la première ailette de première unité et la seconde ailette de première unité, de sorte que
∘ le premier pied de première unité est adjacent au premier front de première ailette de deuxième unité en laissant un premier écartement,
∘ la première surface de première ailette de première unité est contiguë à la première surface de première ailette de deuxième unité, et
∘ la première surface de seconde ailette de première unité est contiguë à la seconde surface de première ailette de deuxième unité,
- au moins l'une de la première surface de première ailette de première unité et de la première surface de première ailette de deuxième unité ayant une première structure ondulée,
- la première structure ondulée formant des premiers canaux entrants entre la première surface de première ailette de première unité et la première surface de première ailette de deuxième unité,
- au moins un premier canal entrant configuré pour
o former un premier flux entrant de réfrigérant depuis le premier front de première ailette de première unité vers le premier pied de première unité et
∘ amener le premier flux entrant de réfrigérant à se heurter et à s'élargir latéralement sur le premier pied de première unité.

2. Refroidisseur selon la revendication 1,
- au moins l'une de la première surface de seconde ailette de première unité et de la seconde surface de première ailette de deuxième unité ayant une deuxième structure ondulée,
- la deuxième structure ondulée formant des premiers canaux inversés entre la première surface de seconde ailette de première unité et la seconde surface de première ailette de deuxième unité,
- les premiers canaux inversés étant décalés par rapport aux premiers canaux entrants,
- chacun de deux premiers canaux inversés voisins, qui sont le plus près du premier canal entrant, étant configuré pour
∘ recevoir une partie du premier flux entrant de réfrigérant heurté et élargi et
∘ former un premier flux inversé de réfrigérant depuis le premier pied de première unité vers le front de seconde ailette de première unité.

3. Refroidisseur selon la revendication 2,
- le premier front de première ailette de deuxième unité étant un front de première ailette de deuxième unité,
- la seconde ailette de première unité ayant une seconde surface de seconde ailette de première unité,
- la deuxième unité comprenant une seconde ailette de deuxième unité,
- la seconde ailette de deuxième unité ayant un front de seconde ailette de deuxième unité et une première surface de seconde ailette de deuxième unité,
- la première ailette de deuxième unité s'étendant d'un premier pied de deuxième unité au front de première ailette de deuxième unité,
- la seconde ailette de deuxième unité s'étendant du premier pied de deuxième unité au front de seconde ailette de deuxième unité,
- la seconde ailette de première unité étant située entre la première ailette de deuxième unité et la seconde ailette de deuxième unité de sorte que
∘ le premier pied de deuxième unité est adjacent au front de seconde ailette de première unité en laissant un deuxième écartement,
∘ la seconde surface de seconde ailette de première unité est contiguë à la première surface de seconde ailette de deuxième unité,
- les premiers canaux inversés étant des seconds canaux entrants,
- le premier flux inversé de réfrigérant étant un second flux entrent de réfrigérant,
- au moins un second canal entrant configuré pour
∘ former le second flux entrant de réfrigérant depuis le front de première ailette de deuxième unité vers le premier pied de deuxième unité,
∘ amener le second flux entrant de réfrigérant à se heurter et à s'élargir latéralement sur le premier pied de deuxième unité,
- au moins l'une de la première surface de seconde ailette de deuxième unité et de la seconde surface de seconde ailette de première unité ayant une troisième structure ondulée,
- la troisième structure ondulée formant des seconds canaux inversés entre la première surface de seconde ailette de deuxième unité et la seconde surface de seconde ailette de première unité,
- les seconds canaux inversés étant décalés par rapport aux seconds canaux entrants,
- chacun de deux seconds canaux inversés voisins, qui sont le plus près dudit second canal entrant, étant configuré pour
∘ recevoir une partie du second flux entrant de réfrigérant heurté et élargi, et
∘ former un second flux inversé de réfrigérant depuis le premier pied de deuxième unité vers le front de seconde ailette de deuxième unité.

4. Refroidisseur selon la revendication 2,
- la première ailette de deuxième unité ayant un second front de première ailette de deuxième unité opposé au premier front de première ailette de deuxième unité,
- le refroidisseur comprenant une troisième unité,
- la troisième unité comprenant une première ailette de troisième unité, et une seconde ailette de troisième unité,
∘ la première ailette de troisième unité s'étendant d'un premier pied de troisième unité à un front de première ailette de troisième unité,
∘ la seconde ailette de troisième unité s'étendant du premier pied de troisième unité à un front de seconde ailette de troisième unité,
∘ la première ailette de troisième unité ayant une première surface de première ailette de troisième unité,
∘ la seconde ailette de troisième unité ayant une première surface de seconde ailette de troisième unité.

5. Refroidisseur selon la revendication 4,
- la première ailette de deuxième unité étant en outre située au moins en partie entre la première ailette de troisième unité et la seconde ailette de troisième unité de sorte que
∘ le premier pied de troisième unité est adjacent au second front de première ailette de deuxième unité en laissant un troisième écartement,
∘ la première surface de première ailette de troisième unité est contiguë à la première surface de première ailette de deuxième unité, et
∘ la première surface de seconde ailette de troisième unité est contiguë à la seconde surface de première ailette de deuxième unité.

6. Refroidisseur selon la revendication 4,
- la première ailette de deuxième unité étant en outre située au moins en partie voisine de la première ailette de troisième unité de sorte que
∘ le premier pied de troisième unité est adjacent au second front de première ailette de deuxième unité en laissant un quatrième écartement,
∘ la première surface de première ailette de troisième unité est contiguë à la seconde surface de première ailette de deuxième unité
- le premier pied de troisième unité étant agencé pour recevoir du réfrigérant depuis l'entrée.

7. Refroidisseur selon l'une quelconque des revendications 4 à 6,
o la troisième unité comprenant un plan pour recevoir une seconde partie à refroidir et
∘ le troisième plan étant en contact thermique ininterrompu avec le premier pied de troisième unité.

8. Refroidisseur selon l'une quelconque des revendications précédentes,
- le refroidisseur étant un refroidisseur d'élément électronique et
- la première partie à refroidir étant un élément électronique.

9. Refroidisseur selon l'une quelconque des revendications précédentes,
- la deuxième unité étant en matériau plastique.

10. Refroidisseur selon l'une quelconque des revendications précédentes,
- l'entrée étant agencée et configurée pour être en amont du premier écartement, et
- la sortie étant agencée et configurée pour être en aval des premiers canaux inversés.

11. Refroidisseur selon l'une quelconque des revendications précédentes,
- la première unité ou la deuxième unité étant un composant à ailettes en un matériau contenant de l'aluminium.

12. Refroidisseur selon l'une quelconque des revendications précédentes,
- le premier pied de première unité est configuré pour provoquer une division du premier flux entrant de réfrigérant en deux flux partiels,
- les deux flux partiels entrant dans lesdits deux premiers canaux inversés voisins.

13. Refroidisseur selon l'une quelconque des revendications précédentes,
- le premier pied de première unité étant un côté d'une paroi de refroidisseur conductrice de chaleur,
- le premier plan étant un côté opposé de la paroi de refroidisseur conductrice de chaleur.

14. Refroidisseur selon l'une quelconque des revendications précédentes,
- la première unité et la deuxième unité sont configurées pour former un logement.

15. Refroidisseur selon l'une quelconque des revendications 4 à 13,
- la première unité et la troisième unité sont configurées pour former un logement, en particulier, et la deuxième unité est configurée pour former le logement en combinaison avec la première et la troisième unité.
